# EUROPÄISCHE PATENTSCHRIFT

(11) **EP 1 999 779 B1**
(45) Veröffentlichungstag und Bekanntmachung des Hinweises auf die Patenterteilung: **10.09.2014**
(21) Anmeldenummer: 07723216.3
(22) Anmeldetag: 13.03.2007
(51) Int. Cl.: G03F 7/16, H01L 21/67

(54) **VORRICHTUNG UND VERFAHREN ZUM BESCHICHTEN EINES MIKRO- UND/ODER NANOSTRUKTURIERTEN STRUKTURSUBSTRATS SOWIE BESCHICHTETES STRUKTURSUBSTRAT**
DEVICE AND METHOD FOR COATING A MICRO- AND/OR NANO-STRUCTURED STRUCTURAL SUBSTRATE AND COATED STRUCTURAL SUBSTRATE
DISPOSITIF ET PROCÉDÉ DE REVÊTEMENT D'UN SUBSTRAT STRUCTUREL MICROSTRUCTURÉ ET/OU NANOSTRUCTURÉ ET SUBSTRAT STRUCTUREL DOTÉ D'UN REVÊTEMENT

(30) Priorität: 28.03.2006 EP 06006328; 28.03.2006 US 390822
(43) Veröffentlichungstag der Anmeldung: 10.12.2008
(73) Patentinhaber: Thallner, Erich, 4782 St. Florian (AT)
(72) Erfinder: Thallner, Erich, 4782 St. Florian (AT)
(74) Vertreter: Schweiger, Johannes
(86) Internationale Anmeldenummer: PCT/EP2007/002206
(87) Internationale Veröffentlichungsnummer: WO 2007/112833

(56) Entgegenhaltungen:
- EP-A- 0 540 447
- WO-A-86/02744
- FR-A1- 2 597 372
- JP-A- 6 151 295
- JP-A- 55 166 923
- US-A- 4 290 384
- US-A- 5 993 546
- US-A1- 2001 001 407
- US-A1- 2002 176 936
- US-B1- 6 245 150
- US-B1- 6 485 568

## Beschreibung

Die Erfindung betrifft eine Vorrichtung und ein Verfahren zum Beschichten eines mikro- und/oder nanostrukturierten Struktursubstrats sowie ein mit einer solchen Vorrichtung und/oder einem solchen Verfahren beschichteten Struktursubstrat.

Bei MEMS (mikro-elektro-mechanische Systeme), MOEMS (mikro-optoelektro-mechanische Systeme) und NEMS (nano-elektro-mechanische Systeme) handelt es sich um eine Kombination aus mechanischen sowie optischen Elementen, Sensoren, Aktoren und elektronischen Schaltungen auf einem Struktursubstrat. Weiterhin können MEMS und NEMS optische, chemische und/oder biologische Komponenten enthalten. Für die Herstellung von MEMS und NEMS ist es meistens notwendig, die Oberfläche des strukturierten Substrates, insbesondere eines Wafers, bevorzugt aus Halbleitermaterialien und/oder verformbaren Kunststoffen, mit einer Beschichtung zu versehen. Meist wird hierfür Fotolack verwendet, um in einem weiteren Verfahrensschritt lithographische Strukturen zu übertragen.

Beschichtungsverfahren sind auch in US 2002/0176936 A1, US 4,290,384, US 6,485,568 B1, EP 0 540 447 A1, US 6,245,150, WO 86/02744, JP 06151295, US 2001/0001407 und US 5, 993, 546 gezeigt.

Die Beschichtung derartiger mikro- und/oder nanostrukturierter Struktursubstrate gestaltet sich als schwierig. Im Unterschied zur Halbleiterindustrie, wo Wafer mit einer vergleichsweise ebenen Oberfläche verwendet werden, handelt es sich bei den mikro- und/oder nanostrukturierten Struktursubstraten der MEMS/MOEMS und NEMS um vergleichsweise stark strukturierte Substrate. Diese tiefen Strukturen werden durch Nass- oder Trockenätzen, Prägen oder Formen erzeugt und können verschiedenste Formen sowie unterschiedlichste Tiefen und Flankenausformungen haben. Die Strukturen des Struktursubstrats haben häufig steile Flanken und des Öfteren sogar senkrechte Seitenwände. Derzeit ist es üblich, als Gräben und/oder Löcher ausgebildete Vertiefungen mit einer Tiefe von etwa 300 µm und einer Breite oder einem Durchmesser der oberen Öffnung von etwa 100 µm und einem Neigungswinkel der Seitenwände von bis zu 70° gleichmäßig belackt werden. Die aus der Halbleiterindustrie bekannten Verfahren zur Oberflächenbeschichtung wie Spinbelackung, Aufbringen von Fotolackfolien oder Tauchbelackung eignen sich nicht, da die Beschichtungssubstanz nicht bis auf den Boden der Vertiefungen vordringen kann. Heute ist es üblich, das Struktursubstrat im Sprayverfahren zu beschichten. Hierbei wird mit einer Zerstäuberdüse ein feiner Beschichtungssubstanznebel unter Normaldruckatmosphäre auf die Oberfläche des Struktursubstrats aufgebracht, wobei der Sprühnebel mit Luft/Sauerstoff oder Stickstoff (N²) gelenkt wird. Dabei besteht häufig das Problem, dass die Beschichtungssubstanztröpfchen aufgrund der Oberflächenspannung die schmalen Öffnungen der Vertiefungen verschließen und nicht die gesamten Seitenwände und die Böden der Vertiefungen benetzt. Weiterhin ist es bekannt, den Sprühnebel durch elektrostatische Aufladung, ähnlich dem Pulverbeschichtungsverfahren, bei Normaldruckatmosphäre auf das Struktursubstrat aufzubringen. Die dabei benötigte hohe elektrische Spannung kann jedoch die empfindlichen Strukturen bzw. Schaltungen des Struktursubstrats zerstören.

Der Erfindung liegt die Aufgabe zugrunde ein Verfahren zum Beschichten eines mikro- und/oder nanostrukturierten Struktursubstrats vorzuschlagen, mit denen eine gleichmäßige Beschichtung der strukturierten Oberfläche des Struktursubstrats mit einer Beschichtungssubstanz möglich ist.

Diese Aufgabe mit den Merkmalen des Anspruchs 1 gelöst.

Vorteilhafte Weiterbildungen der Erfindung sind in den Unteransprüchen angegeben.

Der Erfindung liegt der Gedanke zugrunde, das Struktursubstrat auf einer Trägereinrichtung in einer Vakuumkammer anzuordnen. Die Beschichtungssubstanz wird vor und/oder während und/oder nach der Evakuierung der Vakuumkammer in diese eingebracht. Durch das Anlegen eines Unterdrucks an die Vakuumkammer wird die Luft auf der Oberflächenstruktur, d.h. aus den Vertiefungen des Struktursubstrats herausgesaugt. Schon während und/oder nach dem Einbringen der Beschichtungssubstanz in die Vakuumkammer wird das Druckniveau in der Vakuumkammer, bevorzugt schlagartig, erhöht. Hierdurch wird die Beschichtungssubstanz in die Vertiefungen des Struktursubstrats hineinbefördert/gezogen, wodurch auch sehr tiefe und schmale Vertiefungen gleichmäßig beschichtet werden. Als Beschichtungssubstanz wird bevorzugt Fotolack eingesetzt. Es ist jedoch auch möglich, das Struktursubstrat mit anderen Beschichtungssubstanzen, wie Oberflächenaktivierungsmittel, Lösungsmittel, Haftverbesserern oder anderen Chemikalien zu beschichten. Es liegt im Rahmen der Erfindung das Struktursubstrat mehrfach hintereinander, bevorzugt mit unterschiedlichen Beschichtungssubstanzen, zu behandeln bzw. zu beschichten.

Unter Struktursubstrat wird beispielsweise ein Substrat mit einer Topographie verstanden, wobei das Struktursubstrat aus Halbleitermaterial wie beispielsweise Silikon oder einem Verbundhalbleitermaterial besteht. Bei einigen Anwendungen kann das Substrat auch aus Keramik, Glas, Kunststoff oder Kohlenstoff gebildet sein. Besonders vorteilhaft ist die vorliegende Erfindung für Vertiefungen im Struktursubstrat, wie Gitterlücken (Vias), bei welchen der Durchmesser der Öffnung wesentlich kleiner bemessen ist als die Tiefe der Vertiefung. Typische Abmessungen solcher Vertiefungen reichen von 300 µm Öffnungsdurchmesser und 700 µm Tiefe bis zu 5 µm Durchmesser und 100 µm Tiefe. Die Seitenwandprofile der Vertiefungen können sich senkrecht nach unten erstrecken, aber auch jeweils um bis zu 45° nach innen oder außen geneigt sein. Ein typisches Verhältnis von Durchmesser zu Tiefe der Vertiefungen ist daher 1 zu 2 bis 1 zu 20, insbesondere zu 4 bis 1 zu 20, bevorzugt 1 zu 8 bis 1 zu 20.

Es gibt verschiedene Möglichkeiten, die Beschichtungssubstanz in die Vakuumkammer einzubringen. Gemäß einer besonders einfachen Variante wird die Beschichtungssubstanz im flüssigen Zustand durch eine Einlaufleitung in die Vakuumkammer eingeleitet. Vorteilhafter zur Erzielung einer gleichmäßigen Beschichtung ist jedoch das Vernebeln der Beschichtungssubstanz, beispielsweise innerhalb der Vakuumkammer. Hierzu können Sprühdüsen, Zerstäuberdüsen und/oder Ultraschallzerstäuber eingesetzt werden. Umso feiner der Beschichtungssubstanznebel ist, desto gleichmäßiger ist das Beschichtungsergebnis.

Es hat sich als vorteilhaft erwiesen, das Struktursubstrat vor der Erhöhung des Druckniveaus in der Vakuumkammer, insbesondere mit Hilfe von Heizelementen der Trägereinrichtung zu erwärmen.

Optimale Ergebnisse werden erzielt, wenn das Struktursubstrat vor und/oder während des Einbringens der Beschichtungssubstanz, insbesondere mittels Kühlelementen der Trägereinrichtung, wieder abgekühlt wird. Hierdurch wird die Kondensation von Beschichtungssubstanznebel in den Vertiefungen des Struktursubstrats unterstützt. Mit Hilfe der Heiz- und/oder Kühlelemente können verschiedene Temperaturprofile und -verläufe realisiert werden, wodurch das Beschichtungsergebnis bei unterschiedlichen Struktursubstraten oder Beschichtungssubstanzen beeinflussbar ist.

Zusätzlich oder alternativ ist es denkbar, das Struktursubstrat, bevorzugt mittels der Trägereinrichtung, während oder nach der Einbringung von Beschichtungssubstanz in Rotation zu versetzen, um eine optimale Verteilung der Beschichtungssubstanz auf der Oberfläche des Struktursubstrats zu gewährleisten. Hierbei kann auch die Vernebelungsdüse oder die Einlaufleitung relativ zu dem Struktursubstrat bewegt werden. Besonders vorteilhaft ist es, die Beschichtungssubstanz spiralförmig auf das Struktursubstrat aufzutragen. Gemäß einer bevorzugten Ausführungsform ist vorgesehen, dass die Druckerhöhung nach der Evakuierung der Vakuumkammer gleichzeitig mit dem, bzw. durch das Einbringen von Beschichtungssubstanz erfolgt.

Gemäß der bevorzugten Ausführungsform ist zusätzlich zu der Vakuumkammer eine Vernebelungskammer vorgesehen, die über mindestens eine Verbindungsleitung mit der Vakuumkammer verbunden ist. Innerhalb der Vernebelungskammer sind Vernebelungsmittel, insbesondere mindestens eine Düse und/oder andere geeignete Zerstäubungsgeräte, zum Vernebeln der Beschichtungssubstanz vorgesehen. Mithilfe der Vernebelungsmittel wird die Beschichtungssubstanz in der Vernebelungskammer vernebelt. Das Druckniveau in der Vernebelungskammer ist dabei höher als das Druckniveau der evakuierten Vakuumkammer. Noch während oder nach dem Vernebelungsprozess in der Vernebelungskammer wird die mindestens eine Verbindungsleitung zwischen Vernebelungskammer und Vakuumkammer geöffnet, wodurch schlagartig mit Überdruck der Beschichtungssubstanznebel von der Vernebelungskammer in die Vakuumkammer einströmt, wodurch wiederum der Beschichtungssubstanznebel in die Vertiefungen des Struktursubstrates hineinbefördert/hineingezogen wird und gleichmäßig an den Seitenwänden und dem Boden anhaftet.

Optimale Ergebnisse werden erzielt, wenn die Beschichtungssubstanz bzw. der Beschichtungssubstanznebel vor dem Einbringen in die Vakuumkammer innerhalb der Vernebelungskammer erwärmt wird. Bevorzugt erfolgt das Öffnen der mindestens einen Verbindungsleitung erst nachdem eine gewünschte Beschichtungssubstanzkonzentration in der Vernebelungskammer vorherrscht. Es ist denkbar, die Beschichtungssubstanzkonzentration in der Vernebelungskammer, vorzugsweise durch optische oder chemische Sensoren zu überwachen. Gemäß einer einfachen Ausführungsform kann jedoch auch die Vernebelungskammer über eine vorgegebene Zeitspanne mit Beschichtungssubstanz beschickt werden, bevor die Verbindung zur Vakuumkammer hergestellt wird.

In Weiterbildung ist vorgesehen, dass die Vernebelungskammer volumen veränderlich ausgebildet ist. Bevorzugt weist die Vernebelungskammer eine Bodenplatte auf, die über einen Faltenbalg an die restliche Vernebelungskammer angeschlossen ist. Hierdurch ist es möglich, über die Veränderung des Volumens der Vernebelungskammer Einfluss auf die Konzentration des Beschichtungssubstanznebels innerhalb der Vernebelungskammer sowie Einfluss auf das Druckniveau innerhalb der Vernebelungskammer zu nehmen.

Mit Vorteil weist die Vernebelungskammer auch einen Abfluss auf, um überschüssige Beschichtungssubstanz abführen zu können.

Es ist denkbar, mehrere Beschichtungsvorgänge nacheinander, insbesondere mit unterschiedlichen Beschichtungssubstanzen, vorzunehmen.

Bei entsprechend ausgestalteten Strukturen kann das Einbringen der Beschichtungssubstanz ohne Druckänderung gegenüber der Umgebung, insbesondere bei Atmosphärendruck erfolgen, wobei die Einbringung in flüssiger Form, insbesondere als Flüssigkeitsstrahl, erfolgt und die Beschichtungssubstanz einen Lösungsmittelanteil von mindestens 25 Vol.-%, insbesondere mindestens 40 Vol-%, vorzugsweise mindestens 60 Vol-%, besonders bevorzugt mindestens 70 Vol-% aufweist. Der Flüssigkeitsstrahl soll möglichst geschlossen auf das Struktursubstrat aufgetragen werden, um in die entsprechenden Vertiefungen geschlossen eindringen zu können. Hierdurch wird erreicht, dass sich keine Hohlräume in den Vertiefungen bilden. Die Beschichtungssubstanz soll die Vertiefungen möglichst vollständig ausfüllen. Durch den hohen Lösungsmittelanteil, der später beispielsweise durch Hitzeeinwirkung verdampft, wird die optimale, homogene Beschichtung der Oberfläche der Vertiefungen und der Oberfläche des Struktursubstrats erreicht.

Weitere Vorteile und zweckmäßige Ausführungen sind den weiteren Ansprüchen, der Figurenbeschreibung und den Zeichnungen zu entnehmen.

Es zeigen:
- Fig. 1: ein erstes Beispiel einer Vorrichtung zum Beschichten eines mikro- und/oder nanostrukturierten Struktursubstrats, bei der die Beschichtungssubstanz unmittelbar in einer Vakuumkammer vernebelt wird;
- Fig. 2: ein zweites Beispiel Vorrichtung mit einer Vernebelungskammer, die über absperrbare Verbindungsleitungen mit der Vakuumkammer verbunden ist;
- Fig. 3: Darstellung der Vorrichtung im Verfahrensschritt 1 (Anlegen eines Unterdrucks);
- Fig. 4: Darstellung der Vorrichtung im Verfahrensschritt 2 (Aufbringen der Beschichtungssubstanz);
- Fig. 5: Darstellung der Vorrichtung im Verfahrensschritt 3 (Erhöhen des Druckniveaus);
- Fig. 6: Darstellung eines weiteren Verfahrensschritts, nämlich des Aufheizens des Struktursubstrats und
- Fig. 7: Darstellung des Verfahrensschritts des Aufheizens in einem fortgeschritteneren Stadium im Vergleich mit dem in Fig. 6 dargestellten Stadium mit ausschnittsweiser Vergrößerung der Vertiefungen im Struktursubstrat.

In den Figuren sind gleiche Bauteile und Bauteile mit gleicher Funktion mit den gleichen Bezugszeichen versehen.

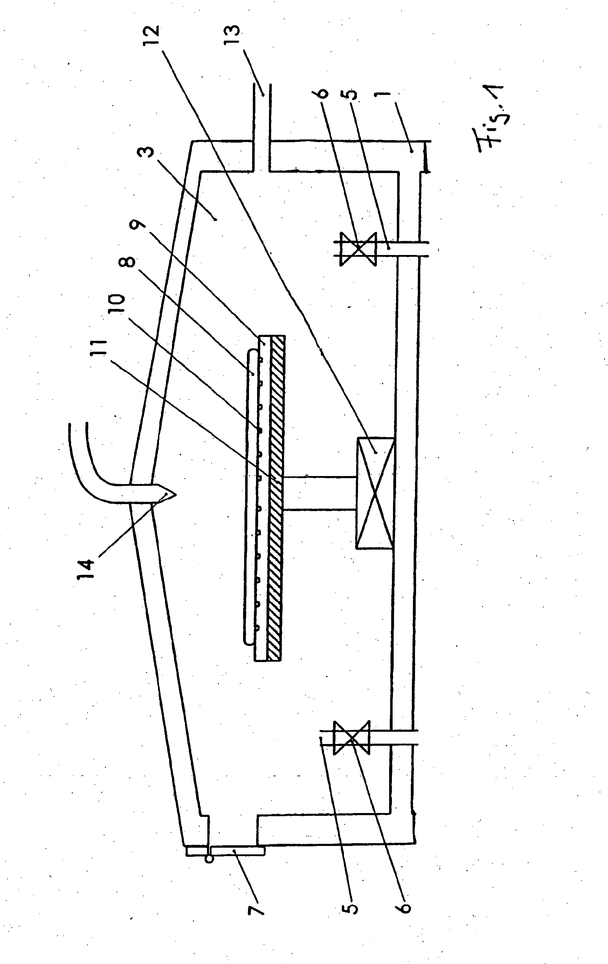

In Fig. 1 ist eine Vorrichtung 1 zum Beschichten eines mikro- und/oder nanostrukturierten Struktursubstrats 8, hier eines Silizium-Wafers, dargestellt. Das Struktursubstrat 8 weist auf seiner in der Zeichnungsebene nach oben weisenden Oberfläche eine Strukturierung mit Vertiefungen auf, wobei die Vertiefungen bei MEMS eine Tiefe von etwa 100 µm bis etwa 400 µm aufweisen. Die Breite bzw. der Durchmesser der oberen Öffnungen dieser Vertiefungen liegt bei MEMS im Bereich von 200 µm bis 100 µm oder weniger. Somit ist bei zumindest einigen der Vertiefungen die Öffnung wesentlich kleiner bemessen als deren Tiefe. Mittels der Vorrichtung 1 ist es möglich, die Oberflächenstruktur des Struktursubstrats 8, insbesondere innerhalb der Vertiefungen, gleichmäßig zu beschichten. Bei NEMS haben die Vertiefungen beispielsweise eine Breite von 20nm und eine Tiefe von 40nm.

Das Struktursubstrat 8 ist in einer Vakuumkammer 3 auf einer Trägereinrichtung 9 (Chuck) fixiert. Zur Fixierung des Struktursubstrats 8 auf der Trägereinrichtung 9 sind Vakuumrillen 10 vorgesehen. Durch Anlegen eines Vakuums an die Vakuumrillen 10 wird das Struktursubstrat 8 mit seiner Unterseite in Richtung Trägereinrichtung 9 gesaugt. Zum Beschicken der Vakuumkammer 9 mit dem Struktursubstrat 8 ist eine verschließbare Klappe 7 vorgesehen. Die Klappe 7 kann auch als Deckel ausgebildet sein.

Die Trägereinrichtung 9 weist ein kombiniertes Heiz-Kühlelement 11 auf, um die Trägereinrichtung 9 und damit das Struktursubstrat 8 zu erwärmen bzw. abzukühlen. Mithilfe des kombinierten Heiz-Kühlelements 11 können die verschiedensten Temperaturprofile bzw. -verläufe realisiert werden.

Die Trägereinrichtung 9 ist mittels eines Motors 12 in der Fixierebene des Struktursubstrats 8 rotierbar, wodurch eine gleichmäßige Verteilung von Beschichtungssubstanz 24 erreicht werden kann, wenn diese nicht in zerstäubter Weise aufgebracht wurde.

Zur Beschickung der Vakuumkammer 3 mit Beschichtungssubstanz ist eine Vernebelungsdüse 14 vorgesehen, wobei als Düse jede Art von Zerstäuberdüse und/oder Einlaufleitung vorgesehen sein kann. Diese ist unmittelbar oberhalb der zu beschichtenden Oberfläche des Struktursubstrates 8 angeordnet und ist vorzugsweise über der Trägereinrichtung 9 beweglich/verschieblich angeordnet, um die Beschichtungssubstanz 24 optimal auf dem Struktursubstrat 8 zu verteilen.

Zum Beaufschlagen der Vakuumkammer 3 mit Unterdruck, also zum Evakuieren der Vakuumkammer 3, ist die Vakuumkammer 3 über eine Vakuumleitung 13 mit einer nicht dargestellten Vakuumanlage verbunden.

Weiterhin sind im Boden der Vakuumkammer 3 zwei beabstandete Verbindungsleitungen 5 mit jeweils einem Absperrventil 6 vorgesehen. Bei offenen Absperrventilen 6 verbinden die Verbindungsleitungen 5 die Vakuumkammer 3 mit einem höheren Druckniveau als das Druckniveau der evakuierten Vakuumkammer 3, bevorzugt mit der Atmosphäre oder einem Überdruck-Druckmittelspeicher.

Das Beschichten des Struktursubstrats 8 erfolgt auf folgende Weise:
Über die geöffnete Klappe 7 wird mittels eines Roboters ein Struktursubstrat 8 auf das Trägerelement 9 abgelegt. Nach Fixierung des Struktursubstrats 8 und Anlegen von Vakuum an die Vakuumrillen 10 wird die Vakuumkammer 3 mittels der Klappe 7 verschlossen. Auch die Absperrventile 6 sind zu diesem Zeitpunkt geschlossen. Es erfolgt nun eine Besprühung des Struktursubstrats 8 durch die Vernebelungsdüse 14 mit Beschichtungssubstanz 24, vorzugsweise einer Oberflächenaktivierungschemie, einem Lösungsmittel oder Fotolack. Die verwendete Beschichtungssubstanz 24 ist je nach Oberflächenbeschaffenheit des Struktursubstrats 8, der Struktur der Gräben oder Löcher prozessspezifisch. In weiterer Vorgangsweise kann nun die Trägereinrichtung 9 mittels des Heiz-Kühlelements 11 erwärmt werden. Bereits während der Erwärmung der Trägereinrichtung 9 und damit des Struktursubstrats 8 wird die Vakuumkammer 3 über die Vakuumleitung 13 evakuiert. Nach einer vorgegebenen Zeit wird die Trägereinrichtung 9 mittels des Heiz-Kühlelements 11 abgekühlt. Daraufhin werden die Absperrventile 6 geöffnet, wodurch Überdruck in die Vakuumkammer 3 schlagartig einströmt und die vernebelte Beschichtungssubstanz 24 in die Vertiefungen 8v des Struktursubstrats 8 hineindrückt und so für eine gleichmäßige Beschichtung sorgt.

Es ist auch ausführbar/machbar, die Vakuumkammer 3 erst nach oder bereits während der Evakuierung mit Beschichtungssubstanz 24 über Düse 14 zu beschicken. Das Beschicken nach der Evakuierung hat den Vorteil, dass die Beschichtungssubstanz 24 während der Beschickung nicht durch die Vakuumleitung 13 abgesaugt wird. Die Absperrventile 6 können bereits während oder nach der Beschickung mit Beschichtungssubstanz 24 geöffnet werden. Vor Öffnung der Absperrventile 6 können prozessspezifische Temperaturprofile durchlaufen werden, wodurch eine Änderung der Konsistenz und/oder rheologischen Eigenschaften der Beschichtungssubstanz 24 erreicht wird.

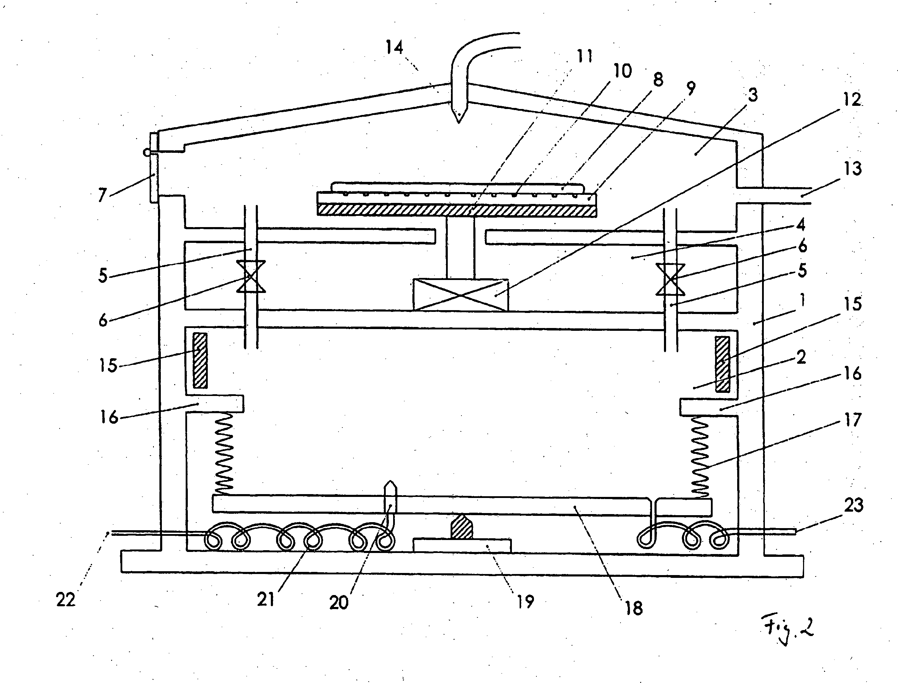

Bei dem Beispiel gemäß Fig. 2 ist zusätzlich zu der Vakuumkammer 3 eine Vernebelungskammer 2 vorgesehen. Der Aufbau der Vakuumkammer 3 mit Trägereinrichtung 9 entspricht im Wesentlichen dem in Fig. 1 gezeigten Aufbau. Auf die in Fig. 2 gezeigte Vernebelungsdüse 14 kann bei dieser Ausführungsform auch verzichtet werden, so dass die Beschickung mit Beschichtungssubstanz 24 ausschließlich über die Vernebelungskammer 2 erfolgt.

Zwischen dem Boden der Vakuumkammer 3 und dem Struktursubstrat 8 ist eine Zwischenwand eingezogen, so dass eine Zwischenkammer 4 gebildet ist, in der der Motor 12 der Trägereinrichtung 9 angeordnet ist. Das Druckniveau der Zwischenkammer 4 entspricht dem Druckniveau der Vakuumkammer 3. Die Zwischenkammer 4 kann auch unter Atmosphärendruck betrieben werden. Dann ist die Welle des Motors 12 im Übergangsbereich zwischen Vakuumkammer 3 und Zwischenkammer 4 abgedichtet.

Im Gegensatz zu dem Beispiel gemäß Fig. 1 verbinden die Verbindungsleitungen 5 mit ihren Absperrventilen 6 die Vakuumkammer 3 nicht mit der Umgebung, sondern mit der Vernebelungskammer 2.

Im oberen Bereich der Vernebelungskammer 2 befinden sich Heizelemente 15 um die Vernebelungskammer 2 beheizen zu können. Unterhalb der Heizelemente 15 befindet sich eine umlaufende Stufe 16, die sich radial nach innen in die Vernebelungskammer 2 erstreckt. Eine Bodenplatte 18 der Vernebelungskammer 2 ist über einen umfänglich geschlossenen Faltenbalg 17 an die Stufe 16 angebunden. Das Volumen der Vernebelungskammer 2 kann über eine Stelleinheit 19 verkleinert oder vergrößert werden, wobei während des Verstellvorgangs sich der Faltenbalg 17 zusammen- oder auseinanderfaltet. In der Bodenplatte 18 ist eine Sprühdüse 20 zur Beschickung der Vernebelungskammer 2 mit Beschichtungssubstanz 24 angeordnet. Über eine flexible Verbindungsleitung 21 und einen Anschluss 22 kann Beschichtungssubstanz 24, vorzugsweise Fotolack, Lösungsmittel oder andere Chemikalien, in die Vernebelungskammer zugeführt werden. Die Sprühdüse 20 dient zum Zerstäuben der Beschichtungssubstanz 24, wodurch das Volumen der Vernebelungskammer 2 mit Beschichtungssubstanznebel befüllbar ist.

Ferner ist eine Öffnung innerhalb der Bodenplatte 18 vorgesehen, die mit einer flexiblen Ablassleitung 23 verbunden ist. Über diese können überschüssige Flüssigkeiten, insbesondere Beschichtungssubstanz 24, die sich in der Nebelkammer 2 absetzt, entfernt werden.

Das Beschichten von Struktursubstraten 8 in der in Fig. 2 gezeigten Vorrichtung 1 erfolgt auf folgende Weise:
Über die Klappe 7 wird ein Struktursubstrat 8 aus Halbleitersubstrat oder geformtem Kunststoff oder Glassubstrat, hier ein Wafer aus Silizium, auf die Trägereinrichtung 9 abgelegt und mittels der Vakuumrillen 10 fixiert. Fakultativ kann nun eine Besprühung des Struktursubstrats 8 mit einer chemischen Substanz, vorzugsweise einer Beschichtungssubstanz 24, durch die Düse 14 erfolgen. Bevorzugt wird das Struktursubstrat 8 mit einer Oberflächenaktivierungssubstanz, einem Lösungsmittels oder Fotolack besprüht. Nach dem fakultativen Besprühvorgang wird die Vakuumkammer 3 evakuiert. Das Struktursubstrat 8 wird mittels des Heiz-Kühlelements 11 zunächst erwärmt und dann wieder, bevorzugt vor der Beschickung der Vakuumkammer 3 mit Beschichtungssubstanz 24, abgekühlt. Währenddessen oder danach wird die Vernebelungskammer 2, welche bevorzugt über die Heizelemente 15 erwärmt ist, durch die Sprühdüse 20 mit einem Beschichtungssubstanznebel befüllt. Das Druckniveau innerhalb der Vernebelungskammer 2 entspricht bevorzugt Atmosphärendruck, ist in jedem Fall jedoch höher als das Druckniveau der evakuierten Vakuumkammer 3. Nach ausreichender Befüllung der Vernebelungskammer 2 mit Beschichtungssubstanz 24, deren Konzentration über nicht dargestellte optische oder chemische Sensoren überwacht wird, werden die Ventile 6 der Verbindungsleitungen 5 geöffnet, wodurch sich die Vakuumkammer 3 schlagartig unter gleichzeitiger Druckzufuhr mit Beschichtungssubstanznebel füllt. Durch die schlagartige Druckerhöhung, insbesondere von Vakuum zu Atmosphärendruck sowie ggf. durch verschiedene Temperaturprofile bzw. -verläufe der Trägereinrichtung 9, wird eine gleichförmige Auskleidung von etwa 300 µm tiefen und etwa 100 µm breiten Hohlräumen, Gräben oder anderen topographischen Figuren, die im Verhältnis zu ihrer Tiefe eine kleine Öffnung nach oben haben, mit einer homogenen Schutzschicht, vorzugsweise einer Fotolackschicht, erhalten.

Je nach Oberflächenbeschaffenheit des Struktursubstrats kann über die Variation der Verweilzeit in der evakuierten Vakuumkammer 3 sowie über das Flutungsprofil (Flüssigkeit oder Vernebeln) sowie über unterschiedliche Temperaturprofile der Trägereinrichtung 9 sowie etwaige Wiederholung des Evakuierungs- und Beschickungszyklus eine genau definierte Beschichtungssubstanzabscheidung an allen vertikalen, tiefen geometrischen Formen des Struktursubstrats 8 erreicht werden. Durch Rotation der Trägereinrichtung 9 wird eine Vergleichmäßigung der Abscheidung erreicht. Ebenso kann eventuell überschüssige Flüssigkeit abgeschleudert werden.

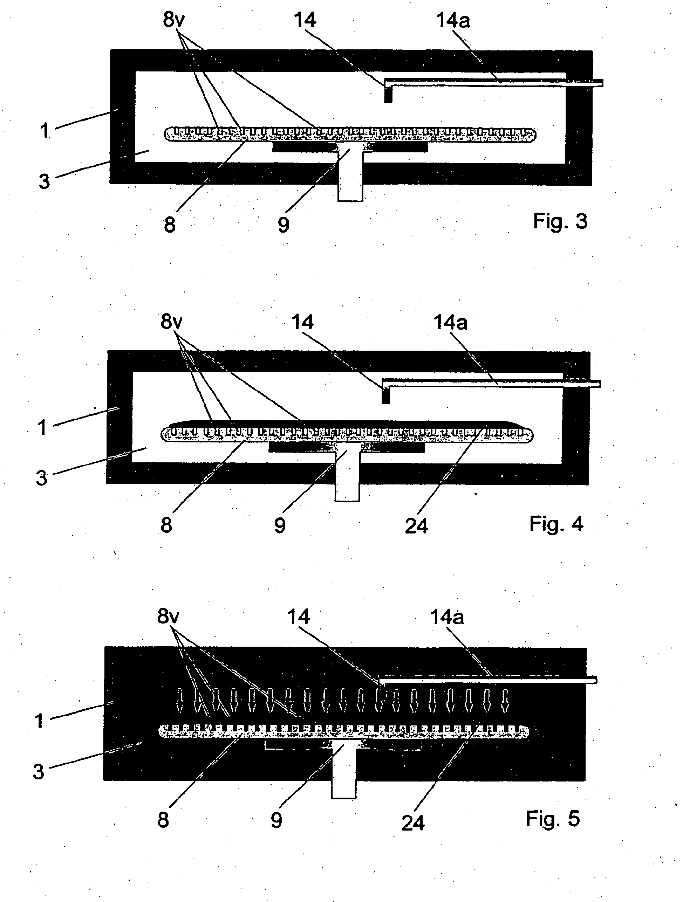

In den Figuren 3 bis 7 ist ein weiterer, möglicher Verfahrensablauf dargestellt. In dem in Fig. 3 dargestellten Verfahrensschritt wird über eine in der schematischen Darstellung gemäß Fig. 3 nicht dargestellte Vakuumleitung (wie Vakuumleitung 13 in Fig. 1) ein Vakuum mit einem Absolutdruck von weniger als 800 mbar, insobesondere weniger als 500 mbar, vorzugsweise 100 bis 400 mbar Absolutdruck durch eine an die Vakuumleitung angeschlossene Vakuumanlage eingestellt. Die Einstellung des Vakuums auf den vorbestimmten Druck hat den Vorteil, dass das durch Unterdruck auf dem Trägerelement 9 befestigte Struktursubstrat 8 auf Grund des im Vergleich zum in der Vakuumkammer 3 vorliegenden Absolutdruck tieferen Unterdrucks auf dem Trägerelement 9 festgelegt bleibt. Ein weiterer Vorteil in dem oben genannten Absolutdruckbereich liegt darin, dass die Verdampfungsrate oder geschwindigkeit des in der Beschichtungssubstanz 24 enthaltenen Lösungsmittels nicht überhöht ist, sondern kontrolliert und gleichmäßig stattfindet.

In dem in Fig. 4 dargestellten Verfahrensschritt wird die Beschichtungssubstanz 24 auf das Struktursubstrat 8 aufgebracht bzw. auf diesem verteilt. Die Verteilung erfolgt beispielsweise durch Rotation des Struktursubstrats 8 bei niedriger Umdrehungsgeschwindigkeit, vorzugsweise zwischen 8 und 40 Umdrehungen pro Minute. Während das Struktursubstrat 8 rotiert, wird die Düse 14 vorzugsweise durch lineare Bewegung parallel zur Struktursubstratoberfläche und entlang dem Arm 14a der Düse 14 bewegt, wobei durch die gleichzeitige Rotation und Hin- und Herbewegung die Beschichtungssubstanz 24 vorzugsweise spiralförmig aufgetragen wird. Der aus der Düse 14 austretende Beschichtungssubstanzvolumenstrom wird so gewählt, um die Oberfläche des Struktursubstrats 8 möglichst vollständig, d.h. mit einer möglichst geschlossenen Beschichtungssubstanzschicht zu benetzen. Der aus der Düse 14 austretende Volumenstrom kann auch durch den Druckunterschied zwischen der Kammer 3 und einem nicht dargestellten Beschichtungssubstanzreservoir oder durch eine Dosierpumpe eingestellt werden. Das Vakuum in der Vakuumkammer 3 zieht die Beschichtungssubstanz 24 in die Vakuumkammer 3 und auf das Struktursubstrat 8. Zu diesem Zeitpunkt fließt die Beschichtungssubstanz 24 auf Grund der Oberflächenspannung der Beschichtungssubstanz 24 in der Regel zumindest (noch) nicht vollständig in die Vertiefungen 8v des Struktursubstrats 8 bzw. die Topographie des Struktursubstrats 8.

Das Auftragen der Beschichtungssubstanz 24 auf das Struktursubstrat 8 kann alternativ auch ohne Rotation des Struktursubstrats 8 allein durch Bewegung des Arms 14a der Düse 14 erfolgen. Eine weitere Alternative besteht darin, die Düse 14 über dem Zentrum des Struktursubstrats 8 anzuordnen und die Beschichtungssubstanz 24 durch Rotation des Struktursubstrats 8 auf diesem zu verteilen. Die Dosierung des aus der Düse 14 austretenden Beschichtungssubstanzvolumens kann auch über eine Dosierpumpe erfolgen und so genauer eingestellt werden.

Es ist auch möglich, dass die Beschichtungssubstanz 24 bereits zumindest teilweise in die Topographie bzw. Vertiefungen 8v des Struktursubstrats 8 eindringt, was insbesondere von der Oberflächenspannung der Beschichtungssubstanz 24 und der Geometrie der Vertiefungen 8v abhängt.

Nach Abschluss des in Fig. 4 dargestellten, soeben beschriebenen Verteilungsschrittes wird die Vakuumkammer 3 mit einem Fluid, das insbesondere zumindest teilweise Stickstoff und/oder Sauerstoff und/oder ein Inertgas enthält, in die Kammer eingelassen. Bevorzugt wird als Fluid Luft verwendet. Das Einströmen kann durch Druckunterschied erfolgen, wobei auch ein Überdruck von außen angelegt werden kann. Durch den Anstieg des Absolutdruckes in der Vakuumkammer 3 wird die auf dem Struktursubstrat 8 befindliche Beschichtungssubstanz 24 in die Vertiefungen 8v bzw. die Topographie des Struktursubstrats 8 gedrückt und füllt diese, vorzugsweise vollständig, aus. Dies ist durch die Pfeile in Fig. 5 schematisch dargestellt.

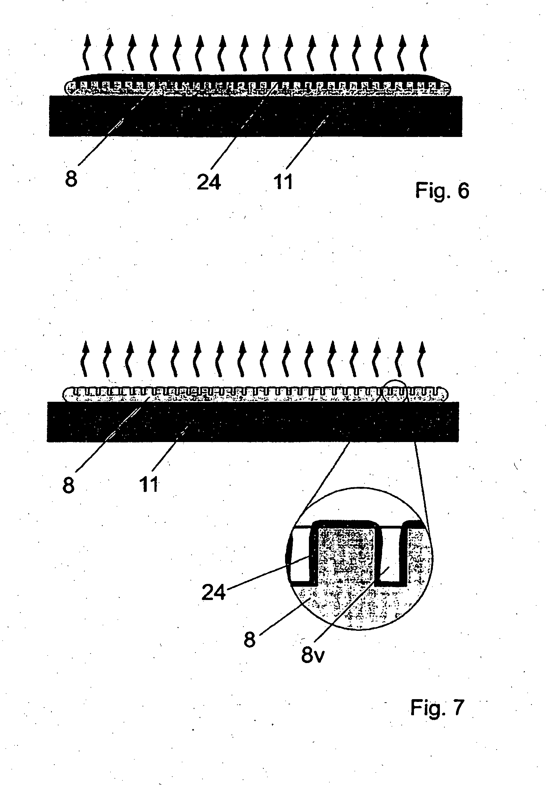

In einem nächsten Schritt wird das Struktursubstrat 8 aus der Vakuumkammer 3 entladen und über einer Heizplatte 11 angeordnet. Bereits bei der, vorzugsweise langsam und in definierter Geschwindigkeit erfolgenden, Annäherung des Struktursubstrats 8 zu der Heizplatte 11 heizt sich das Struktursubstrat 8 und die in den Vertiefungen 8v befindliche Beschichtungssubstanz 24 sowie die auf dem Struktursubstrat 8 befindliche Beschichtungssubstanz 24 definiert auf, wodurch Lösungsmittel und zu verdampfende Inhalte der Beschichtungssubstanz 24 möglichst langsam und definiert verdampfen. Auf Grund des vergleichsweise hohen Anteils an Lösungsmittel in der Beschichtungssubstanz 24 verringert sich das Beschichtungssubstanzvolumen signifikant und es bleibt die in Fig. 7 dargestellte Beschichtung 24, die homogen auf der Topographie bzw. Oberfläche des Struktursubstrats 8 und der Oberfläche der Vertiefungen 8v verteilt ist.

Typische Heizparameter sind beispielsweise 70° C für 1 bis 10 Minuten bei 5 mm Abstand zu der Heizplatte 11 und anschließend 1 bis 10 Minuten bei 0 bis 3 mm Abstand zu der Heizplatte.

Typische Beschichtungssubstanzen 24, die bei dem vorbeschriebenen Beschichtungssystem verwendet werden, sind: positive und negative Fotolacke, dielektrische Materialen wie BCB und Polyimide, Schutz-Coatings. Die Beschichtungssubstanz wird üblicherweise vor der Beschichtung verdünnt, wobei die Verdünnung mit folgenden Verdünnungsmitteln erfolgen kann: Azeton, PGMEA, MEK, NMP, IPA oder Mesitylene oder beliebige Kombinationen davon.

Statt der definierten und langsamen Annäherung des Struktursubstrats 8 an die Heizplatte 11 kann das Struktursubstrat 8 auch unmittelbar auf die Heizplatte 11 aufgelegt werden und/oder über verschiedene Heizplatten nacheinander definiert aufgeheizt werden.

Auch eine Kombination der beschriebenen, einzelnen Verfahrensschritte und/oder einzelnen Vorrichtungsmerkmale ist denkbar.

Vorrichtung und Verfahren zum Beschichten eines mikro- und/oder nanostrukturierten Struktursubstrats sowie beschichtetes Struktursubstrat

### Bezugszeichenliste

- 1: Vorrichtung
- 2: Vernebelungskammer
- 3: Vakuumkammer
- 4: Zwischenkammer
- 5: Verbindungsleitungen
- 6: Absperrventile
- 7: Klappe
- 8: Struktursubstrat
- 8v: Vertiefungen (vias)
- 9: Trägereinrichtung
- 10: Vakuumrillen
- 11: Heiz-Kühlelement
- 12: Motor
- 13: Vakuumleitung
- 14: (Vernebelungs-)düse
- 14a: Arm
- 15: Heizelemente
- 16: Stufe
- 17: Faltenbalg
- 18: Bodenplatte
- 19: Stellelement
- 20: Sprühdüse
- 21: flexible Verbindungsleitung
- 22: Anschluss
- 23: flexible Ablassleitung
- 24: Beschichtungssubstanz

## Patentansprüche

1. Verfahren zum Beschichten eines mikro- und/oder nanostrukturierten Struktursubstrats (8) mit Vertiefungen mit folgenden Verfahrensschritten:
• Beschicken einer Vakuumkammer (3) mit dem Struktursubstrat (8) auf einer Trägereinrichtung (9);
• Evakuieren der Vakuumkammer (3);
• Einbringen einer Beschichtungssubstanz in die zumindest teilweise evakuierte Vakuumkammer (3) und auf das Struktursubstrat (8);
• Erhöhen des Drucks in der Vakuumkammer (3) während und/oder nach dem Einbringen der Beschichtungssubstanz, derart, dass die Beschichtungssubstanz in die Vertiefungen hineinbefördert wird,
**dadurch gekennzeichnet,**
**dass** die Trägereinrichtung (9) mittels eines Motors (12) in der Fixierebene des Struktursubstrats (8) rotierbar ausgebildet ist.

2. Verfahren nach Anspruch 1,
**dadurch gekennzeichnet,**
**dass** die Beschichtungssubstanz, insbesondere nach der Evakuierung der Vakuumkammer (3), flüssig in die Vakuumkammer eingeleitet wird und/oder in der Vakuumkammer (3) vernebelt wird.

3. Verfahren nach Anspruch einem der Ansprüche 1 oder 1,
**dadurch gekennzeichnet,**
**dass** das Struktursubstrat (8) in der Vakuumkammer (3), vorzugsweise über eine vorgegebene Zeitspanne, erwärmt wird.

4. Verfahren nach einem der Ansprüche 1 bis 3,
**dadurch gekennzeichnet,**
**dass** das Struktursubstrat (8), vorzugsweise vor dem Einbringen der Beschichtungssubstanz, insbesondere nach Erwärmen des Struktursubstrats (8), gekühlt wird.

5. Verfahren nach einem der Ansprüche 1 bis 4,
**dadurch gekennzeichnet,**
**dass** als Struktursubstrat (8) ein Halbleitersubstrat oder ein geprägtes oder geformtes Kunststoffmaterial oder ein Glassubstrat, vorzugsweise ein Wafer, mit Vertiefungen, vorzugsweise Gräben oder Löcher, mit einer Tiefe von etwa 10nm bis etwa 400µm verwendet wird.

6. Verfahren nach Anspruch 5,
**dadurch gekennzeichnet,**
**dass** die Breite oder der Durchmesser der Vertiefungen kleiner ist als deren Tiefe.

7. Verfahren nach einem der Ansprüche 1 bis 6,
**dadurch gekennzeichnet,**
**dass** als Beschichtungssubstanz Fotolack und/oder Oberflächenaktivierungsmittel und/oder Lösungsmittel und/oder Haftverbesserer verwendet werden.

8. Verfahren nach einem der Ansprüche 1 bis 7,
**dadurch gekennzeichnet,**
**dass** die Verfahrensschritte nach dem Beschicken der Vakuumkammer (3) mit dem Struktursubstrat (8) mehrfach, vorzugsweise mit unterschiedlichen Beschichtungssubstanzen, wiederholt werden.

9. Verfahren nach der Anspruch 1,
**dadurch gekennzeichnet,**
**dass** die Trägereinrichtung (9) ein Heiz-Kühlelement (11) aufweist.

10. Verfahren nach Anspruch 9,
**dadurch gekennzeichnet,**
**dass** mittels des Heiz-Kühlelements (11) verschiedene Temperaturprofile bzw. -verläufe realisiert werden.

## Claims

1. A method for coating a micro-structured and/or nano-structured structural substrate (8) with recesses, wherein said method comprises the following steps:
• loading the structural substrate (8) into a vacuum chamber (3) on a carrier device (9);
• evacuating the vacuum chamber (3);
• feeding a coating substance into the at least partially evacuated vacuum chamber (3) and onto the structural substrate (8);
• increasing the pressure in the vacuum chamber (3) during and/or after the infeed of the coating substance such that the coating substance is transported into the recesses,
**characterized in**
**that** the carrier device (9) is designed such that it can be rotated in the fixing plane of the structural substrate (8) by means of a motor (12).

2. The method according to claim 1,
**characterized in**
**that** the coating substance is delivered into the vacuum chamber (3), particularly after the evacuation of the vacuum chamber (3), in liquid form and/or atomized in the vacuum chamber (3).

3. The method according to one of claims 1 or 2,
**characterized in**
**that** the structural substrate (8) is heated in the vacuum chamber (3), preferably over a predefined duration.

4. The method according to one of claims 1 to 3,
**characterized in**
**that** the structural substrate (8) is cooled, preferably before the infeed of the coating substance, particularly after the structural substrate (8) has been heated.

5. The method according to one of claims 1 to 4,
**characterized in**
**that** a semiconductor substrate or an embossed or shaped plastic material or a glass substrate, preferably a wafer, with recesses, preferably pits or holes with a depth of about 10 nm to about 400 µm, is used as structural substrate (8).

6. The method according to claim 5,
**characterized in**
**that** the width or the diameter of the recesses is smaller than their depth.

7. The method according to one of claims 1 to 6,
**characterized in**
**that** photoresists and/or surface activating agents and/or solvents and/or adhesion promoters are used as coating substances.

8. The method according to one of claims 1 to 7,
**characterized in**
**that** the steps after loading the structural substrate (8) into the vacuum chamber (3) are repeated several times, preferably with different coating substances

9. The method according to claim 1,
**characterized in**
**that** the carrier device (9) features a heating/cooling element (11).

10. The method according to claim 9,
**characterized in**
**that** different temperature profiles or temperature sequences can be realized by means of the heating/cooling element (11).

## Revendications

1. Procédé de revêtement d'un substrat structurel micro- et/ou nanostructuré (8) doté de creux par les étapes opératoires suivantes :
• revêtement d'une chambre de dépressurisation (3) avec le substrat structurel (8) sur un dispositif porteur (9) ;
• mise sous vide de la chambre de dépressurisation (3) ;
• introduction d'une substance de revêtement dans l'au moins une chambre de dépressurisation (3) au moins partiellement sous vide et sur le substrat structurel (8) ;
• augmentation de la pression dans la chambre de dépressurisation (3) pendant et/ou après l'introduction de la substance de revêtement de manière à ce que la substance de revêtement rentre dans les creux,
**caractérisé en ce**
**que** le dispositif porteur (9) est conçu pour tourner au moyen d'un moteur (12) dans le plan de fixation du substrat structurel (8).

2. Procédé selon la revendication 1,
**caractérisé en ce**
**que** la substance de revêtement est guidée sous forme liquide dans la chambre de dépressurisation (3) et/ou nébulisée dans la chambre de dépressurisation (3), en particulier après l'évacuation de la chambre de dépressurisation (3).

3. Procédé selon l'une des revendications 1 ou 2,
**caractérisé en ce**
**que** le substrat structurel (8) est réchauffé dans la chambre de dépressurisation (3), de préférence pendant un laps de temps prédéfini.

4. Procédé selon l'une des revendications 1 à 3,
**caractérisé en ce**
**que** le substrat structurel (8) est refroidi de préférence avant l'introduction de la substance de revêtement, en particulier après le réchauffement du substrat structurel (8).

5. Procédé selon l'une des revendications 1 à 4,
**caractérisé en ce**
**qu'**on utilise comme substrat structurel (8) un substrat semiconducteur ou une matière plastique gaufrée ou moulée ou un substrat de verre, de préférence une plaquette, doté de creux, de préférence de trous ou de perforations, ayant une profondeur d'environ 10 nm à environ 400 µm.

6. Procédé selon la revendication 5,
**caractérisé en ce**
**que** la largeur ou le diamètre des creux est inférieur à leur profondeur.

7. Procédé selon l'une des revendications 1 à 6,
**caractérisé en ce**
**qu'**on utilise comme substance de revêtement du vernis photosensible et/ou des moyens d'activation de surface et/ou des solvants et/ou des promoteurs d'adhérence.

8. Procédé selon l'une des revendications 1 à 7,
**caractérisé en ce**
**que** les étapes opératoires sont répétées plusieurs fois après le chargement du substrat structurel (8) dans la chambre de pressurisation (3), de préférence avec différentes substances de revêtement.

9. Procédé selon la revendication 1,
**caractérisé en ce**
**que** le dispositif porteur (9) présente un élément de chauffage et de refroidissement (11).

10. Procédé selon la revendication 9,
**caractérisé en ce**
**que** divers profils ou cycles de température sont réalisés au moyen de l'élément de chauffage et de refroidissement (11).
